# DEMANDE DE BREVET EUROPEEN

(11) **EP 1 489 647 A2**
(43) Date de publication de la demande: **22.12.2004**
(21) Numéro de dépôt: 04291416.8
(22) Date de dépôt: 07.06.2004
(51) Int. Cl.: H01L 21/285, H01L 21/28, H01L 21/265, H01L 21/336

(54) **Procédé de formation de siliciure**

(30) Priorité: 20.06.2003 FR 0307475
(71) Demandeur: STMicroelectronics S.A., 92120 Montrouge (FR); Koninklijke Philips Electronics N.V., 5621 BA Eindhoven (NL)
(72) Inventeur: Wacquant, Francois, 38330 Saint Ismier (FR); Regnier, Christophe, 38660 Saint Hilaire du Touvet (FR); Froment, Benoit, 38100 Grenoble (FR); Lenoble, Damien, 38610 Gieres (FR); El Farhane, Rebha, 38000 Grenoble (FR)
(74) Mandataire: Verdure, Stéphane

(57) **Abrégé**

Un procédé de formation de siliciure au dessus d'au moins une portion de silicium (11a,12b,13b) à la surface d'une plaque de matériau semi-conducteur (1), comprend les étapes de :
a) implantation à une profondeur déterminée dans la portion de silicium, à travers une couche de matériau diélectrique (20), d'ions ayant la propriété de freiner la siliciuration des métaux ;
b) traitement thermique ;
c) dépôt d'une couche de métal (30), ledit métal étant apte à former un siliciure par réaction thermique avec le silicium ;
d) traitement thermique rapide adapté pour provoquer la siliciuration du métal déposé à l'étape c) ; et,
e) retrait du métal n'ayant pas réagi au traitement thermique de l'étape d).

Avantageusement, l'épaisseur du siliciure créé à l'étape d) est contrôlée par un choix approprié de la profondeur de l'implantation réalisée à l'étape a).

## Description

La présente invention concerne la fabrication de dispositifs semi-conducteurs, et plus particulièrement la formation des siliciures par réaction thermique avec du silicium.

Elle trouve des applications, notamment, dans la fabrication des transistors MOS (de l'anglais "Metal Oxide Semiconductor") dans toutes les technologies utilisant les siliciures, en particulier les technologies à 0,18 µm, 0,12 µm, 90 nm, ou 65 nm.

Les transistors MOS sont des composants importants des dispositifs semi-conducteurs, et les performances électriques de la grille des transistors MOS affectent directement la qualité de ces dispositifs. La grille d'un transistor MOS comprend typiquement une couche de silicium poly-cristallin (poly-silicium) ou une couche de silicium amorphe utilisée comme couche conductrice principale, et parfois une couche de siliciure, par exemple le siliciure de cobalt (CoSi2), empilée sur la couche conductrice principale. De même, les zones actives de source et de drain du transistor MOS comprennent une couche de silicium dopé, qui peut être recouverte d'une couche de siliciure. Ces couches de siliciure fournissent un bon contact ohmique, et, de ce fait, elles réduisent les résistances de couche du transistor MOS et augmentent la vitesse opérationnelle du dispositif semi-conducteur l'incorporant.

On sait que les procédés de siliciuration utilisant par exemple un dépôt de cobalt (Co), sont sensibles à la présence de défauts à la surface du silicium, en particulier la présence de résidus organiques. De tels résidus peuvent provenir d'une couche de résine ("resist" en anglais), implantée dans le silicium au cours des étapes de formation des zones actives de source et de drain par implantation d'espèces dopantes à travers les bords de ladite couche de résine utilisée comme masque d'implantation. Ils peuvent être à l'origine d'une coupure de siliciure ("salicide cut", en anglais).

Dans l'état actuel de la technique, les défauts de ce type sont supprimés en employant une gravure par pulvérisation ("sputter etch" en anglais), comprenant un bombardement d'ions argon (Ar). Cette gravure, qui est préalable à la mise en oeuvre du procédé de siliciuration proprement dit, permet la formation sans coupures du siliciure sur les grilles et sur les zones actives des transistors MOS.

Néanmoins, un tel bombardement d'ions Ar induit des fuites de jonction. De plus, il est à l'origine d'une re-pulvérisation de silicium sur les flancs des espaceurs ("spacers" en anglais) qui peut provoquer un court-circuit entre la grille et les zones actives de source et/ou de drain (phénomène appelé "bridging" en anglais). Enfin, il engendre également une dégradation de la rugosité du siliciure.

En outre, du fait de leur rugosité (phénomène dit "spiking" en anglais), l'épaisseur des couches de siliciure formées selon les techniques connues dans l'art antérieur est mal contrôlée, essentiellement car elle résulte des conditions de mise en oeuvre de l'étape de siliciuration proprement dite (température et durée d'un traitement thermique de siliciuration).

L'invention a pour objet de proposer un procédé de formation de siliciure qui pallie les inconvénients de l'art antérieur précités.

Ce but est atteint grâce à un procédé de formation de siliciure au dessus d'au moins une portion de silicium à la surface d'une plaque de matériau semi-conducteur, comprenant les étapes de :
a) implantation à une profondeur déterminée dans la portion de silicium, d'ions ayant la propriété de freiner la siliciuration des métaux ;
b) traitement thermique ;
c) dépôt d'une couche de métal, ledit métal étant apte à former un siliciure par réaction thermique avec le silicium ;
d) traitement thermique rapide adapté pour provoquer la siliciuration du métal déposé à l'étape c) ; et,
e) retrait du métal n'ayant pas réagi au traitement thermique de l'étape d).

L'épaisseur du siliciure créé à l'étape d) est contrôlée par un choix approprié de la profondeur de l'implantation réalisée à l'étape a), étant fait observer que celle-ci est elle-même déterminée par les conditions de ladite implantation.

Le procédé s'applique notamment à la fabrication d'un transistor MOS, la (ou les) portion(s) de silicium à siliciurer étant typiquement la zone de grille, la zone de source et/ou la zone de drain.

C'est pourquoi un autre aspect de l'invention concerne un transistor MOS comprenant une couche de siliciure au dessus d'une zone déterminée et comprenant en outre des ions implantés dans ladite zone juste au dessous de la couche de siliciure, lesdits ions ayant la propriété de freiner la siliciuration des métaux.

Un autre aspect de l'invention encore, se rapporte à un dispositif semiconducteur comprenant un tel transistor MOS.

L'implantation effectuée à l'étape a) peut avantageusement, mais non nécessairement être une implantation de pré-amorphisation, consistant par exemple à bombarder la structure avec des ions non dopants (ou PAI, de l'anglais "Pre-Amorphization Implants"). L'espèce implantée est alors de préférence une espèce lourde, qui favorise l'amorphisation du silicium. Une telle implantation de pré-amorphisation permet ainsi de détruire les résidus organiques provenant de l'implantation non volontaire de résine dans le silicium, sans modifier le comportement électrique des portions sous-jacentes.

Une espèce non dopante est soit une espèce neutre soit un gaz rare (dernière colonne de la table périodique des éléments) soit les deux à la fois. Le caractère "neutre" de l'espèce implantée s'apprécie au regard du substrat de silicium sur lequel le transistor MOS est implanté, en ce sens qu'une espèce neutre est une espèce qui a la même valence que ledit substrat. Une espèce neutre typiquement utilisée en microélectronique est le germanium (Ge). Des gaz rares pouvant être utilisés à la place du Ge sont par exemple le xénon (Xe) et l'argon (Ar).

Le caractère "lourd" de l'espèce implantée s'apprécie au regard de sa masse atomique, par exemple exprimée en unités de masse atomique (uma) qui est l'unité de l'Union Internationale de Chimie Pure et Appliquée (UICPA) basée sur la masse atomique de l'isotope 12 du carbone. Par exemple, la masse atomique du Ge vaut 72,61 uma, celle de l'Ar vaut 39,948 uma, et celle du Xe est égale à 131,29 uma. Plus l'espèce est lourde, et plus la dose implantée peut être faible.

Les espèces indiquées dans les deux paragraphes précédents sont connues pour présenter la propriété de freiner la siliciuration des métaux. Selon un avantage de l'invention, le contrôle de la profondeur d'implantation des ions d'une telle espèce, via un choix approprié des conditions de l'implantation réalisée à l'étape a), permet de contrôler l'épaisseur de la couche de siliciure créée à l'étape d).

Les métaux ayant la propriété de former un siliciure par traitement thermique avec du silicium sont par exemple le Co, le nickel (Ni), le platine (Pt) ou le titane (Ti). Leurs siliciures correspondants sont respectivement le CoSi2, le PtSi, le NiSi, et le TiSi2. De tels métaux peuvent être déposés, par exemple, par des procédés de dépôt chimique en phase vapeur à basse pression (ou LPCVD, de l'anglais "Low Pressure Chemical Vapour Deposition") ou par procédé de pulvérisation ("sputtering" en anglais).

Avantageusement, l'implantation de l'étape a) peut avoir lieu à travers une couche de matériau diélectrique, ce qui permet de limiter la canalisation des ions dans le silicium. Cette couche de matériau diélectrique est retirée lors d'une étape de retrait venant entre les étapes b) et c).

Par ailleurs, le traitement thermique de l'étape b) a pour fonction de réparer les défauts générés dans la structure du fait de l'implantation des ions.

L'étape b) peut être mise en oeuvre par un recuit d'activation d'espèces dopantes préalablement implantées dans le silicium (notamment dans les zones de source et de drain des transistors MOS de la plaque). Un tel recuit est une étape conventionnelle dans la fabrication d'un transistor MOS. De plus, les étapes c) à e) faisant par ailleurs partie du procédé de siliciuration conventionnel, la mise en oeuvre de l'invention peut alors ne nécessiter qu'une étape supplémentaire par rapport à la fabrication d'un transistor MOS selon l'art antérieur, à savoir l'étape d'implantation a).

Il a été constaté en pratique, avec une implantation d'ions Ge+, une réduction d'un facteur 100 des fuites de jonction dans un transistor MOS, par rapport à la mise en oeuvre d'un procédé selon l'art antérieur.

En choisissant correctement la dose d'ions Ge+ implantée, on peut en outre réduire les résistances de couche de 30 %.

D'autres caractéristiques et avantages de l'invention apparaîtront encore à la lecture de la description qui va suivre. Celle-ci est purement illustrative et doit être lue en regard des dessins annexés sur lesquels :

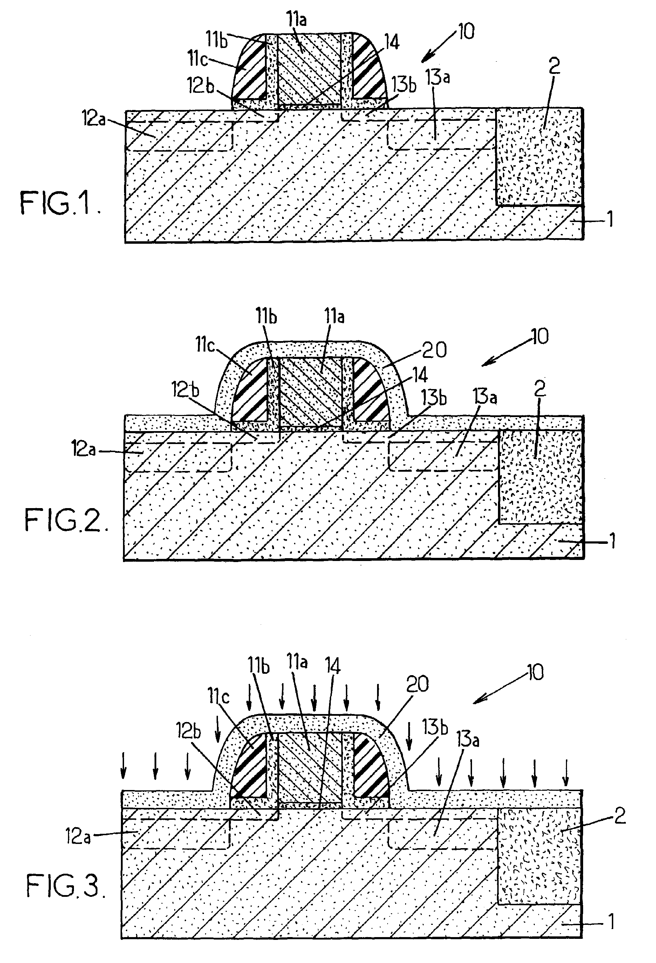

- les figures 1 à 6 sont des vues en coupe servant à illustrer différentes étapes de la mise en oeuvre d'un procédé selon l'invention.

Dans les dessins, des éléments identiques portent les mêmes références. Sur chaque figure, on a représenté une vue en coupe d'un transistor 10 qui est un transistor MOS réalisé à la surface d'une plaque de matériau semi-conducteur ("Wafer" en anglais) formant un substrat de silicium 1.

Le schéma de la figure 1 représente le transistor 10 avant le début du procédé de siliciuration selon l'invention.

La grille du transistor 10 comprend une couche 11a de silicium poly-cristallin (poly-silicium) ou une couche de silicium amorphe utilisé comme couche conductrice principale. La couche 11a est rapportée à la surface du substrat 1, dont elle est isolée par une fine couche 14 d'oxyde de grille, par exemple en dioxyde de silicium (Si02). La couche conductrice principale 11a et la couche d'isolant 14 sont entourées d'une couche de nitrure 11 b s'étendant parallèlement à une direction perpendiculaire à la surface du substrat 1. La couche 11 b comprend également une partie s'étendant parallèlement à la surface du substrat 1, en s'éloignant des couches 11a et 14. Le nitrure peut être du nitrure de silicium (SiN). Enfin, la grille du transistor 10 comprend un espaceur 11 c, formé d'une portion d'oxyde (par exemple du Si02) recouvrant la totalité de la couche de nitrure 11 b.

Le transistor comprend enfin des zones actives de source et de drain, formées par des zones dopées, sous la surface du substrat 1. Typiquement, les zones de sources et de drain comprennent des zones dopées 12a et 13a s'étendant jusqu'à une certaine profondeur, à partir des limites de l'espaceur 11 c de part et d'autre de la grille 11 a. La portion du substrat 1 située entre ces zones 12a et 13a forme le canal du transistor 10. Typiquement, le transistor comprend en outre des zones 12b et 13b de plus faible dopage et de moindre profondeur que les zones respectivement 12a et 13a, et s'étendant parallèlement à la surface du substrat 1, à partir des extrémités de la zone conductrice principale 11 a de la grille de part et d'autre de celle-ci. Ces zones 12b et 13b forment des extensions (ou LDD, de l'anglais "Lightly Doped Drain"). Enfin, on peut distinguer à la figure 1, une tranchée d'isolation 2 (ou STI, de l'anglais "Shallow Trench Insulation"), par exemple en Si02, ayant pour fonction d'isoler le transistor 10 du reste de la plaque.

Dans une première étape illustrée par le schéma de la figure 2, et qui est optionnelle, on obtient une couche d'isolant 20 par-dessus le transistor 10. Il s'agit d'une couche de matériau diélectrique, par exemple du Si02 déposé par CVD ("Chemical Vapour Deposition"). La couche 20 est une couche conforme, en ce sens qu'elle épouse les contours de la structure formée à la surface du substrat 1.

La couche 20 peut être déposée spécifiquement pour la mise en oeuvre du procédé de l'invention. En variante, elle peut aussi servir, pour une autre opération, de masque formé de l'empilement de ladite couche et d'une couche de nitrure qui est gravée sélectivement, pour protéger certains transistors contre la siliciuration. Dans ce dernier cas, la couche 20 est par exemple une couche de Si02 déposé par CVD à partir du tétraéthylorthosilicate (TEOS). Un tel masque est parfois appelé "masque Si-Protect" dans le jargon de l'Homme du métier.

On notera que la couche 20 recouvre en particulier les zones de silicium du transistor 20 qui sont exposées, à savoir la zone de grille 11 a et une partie des extensions 12b et 13b des zones de source et de drain.

Dans une étape suivante illustrée par le schéma de la figure 3, on procède à l'implantation d'ions dans les zones de silicium à siliciurer, c'est-à-dire dans les zones 11a, 12b et 13b, le cas échéant à travers la couche d'oxyde 20 jusqu'à une profondeur déterminée. Les ions implantés sont d'une espèce ayant la propriété de freiner la siliciuration des métaux.

Il peut s'agir d'une implantation pleine plaque, ce qui évite la formation d'un masque spécifique.

Les ions implantés peuvent avantageusement être des ions non dopants, et de préférence des ions lourds.

Les ions peuvent être sélectionnés dans le groupe comprenant des ions de Ge, Xe, et Ar. On notera qu'il s'agit d'ions non dopants dans la mesure où le Ge a la même valence que le silicium, et/ou le Xe et l'Ar sont des gaz rares. En outre, les ions du Ge, du Xe et de l'Ar sont des ions lourds.

Dans ces conditions, cette implantation réalise une pré-amorphisation du silicium ayant pour conséquence de détruire les résidus d'implantation qui peuvent avoir été préalablement introduits dans le silicium, par exemple lors d'une implantation d'espèces dopantes à travers un masque formé d'une résine photo-lithographiée.

Il est possible que cette implantation soit une implantation pleine plaque, dans la mesure où, les ions étant non dopants, ils n'affectent pas les caractéristiques électriques des structures soumises à cette implantation. En variante, l'implantation peut toutefois être limitée à certaines parties de la plaque de matériau semi-conducteur par utilisation d'un masque approprié.

Dans un exemple, les ions implantés étant des ions Ge+, les conditions d'implantation peuvent être définies par une concentration comprise entre 10¹⁴ et 10¹⁶ particules par unité de surface, une énergie d'implantation comprise entre 5 et 50 KeV, et la température ambiante. Une telle implantation est actuellement bien maîtrisée par l'Homme du métier et ne pose pas de problème particulier.

Le fait de réaliser l'implantation à travers la couche d'isolant 20 permet de limiter la canalisation des ions dans le silicium.

Il est préférable d'effectuer un traitement thermique, c'est-à-dire un chauffage, pour réparer la formation de défauts dans la structure qui est due à l'implantation. De façon avantageuse, ce chauffage peut être confondu avec un recuit d'activation d'espèces dopantes préalablement implantées dans la zone de grille 11a et dans les zones de source et de drain 12a-12b et 13a-13b du transistor 10.

Dans une étape suivante, on procède au retrait de la couche d'isolant 20, par tout procédé approprié, par exemple par attaque chimique, notamment d'acide fluorhydrique (HF). On obtient alors la configuration illustrée par le schéma de la figure 4.

Ainsi qu'il peut être vu sur cette figure, les ions implantés à l'étape précédente ont pénétré jusqu'à une profondeur déterminée D1, à l'intérieur des zones de silicium à siliciurer 11 a, 12b et 13b. Cette profondeur est déterminée en particulier par l'énergie et la dose d'implantation, et par l'épaisseur de la couche d'isolant 20 à travers laquelle cette implantation est réalisée.

Dans les étapes suivantes, on met en oeuvre les étapes de siliciuration classiques.

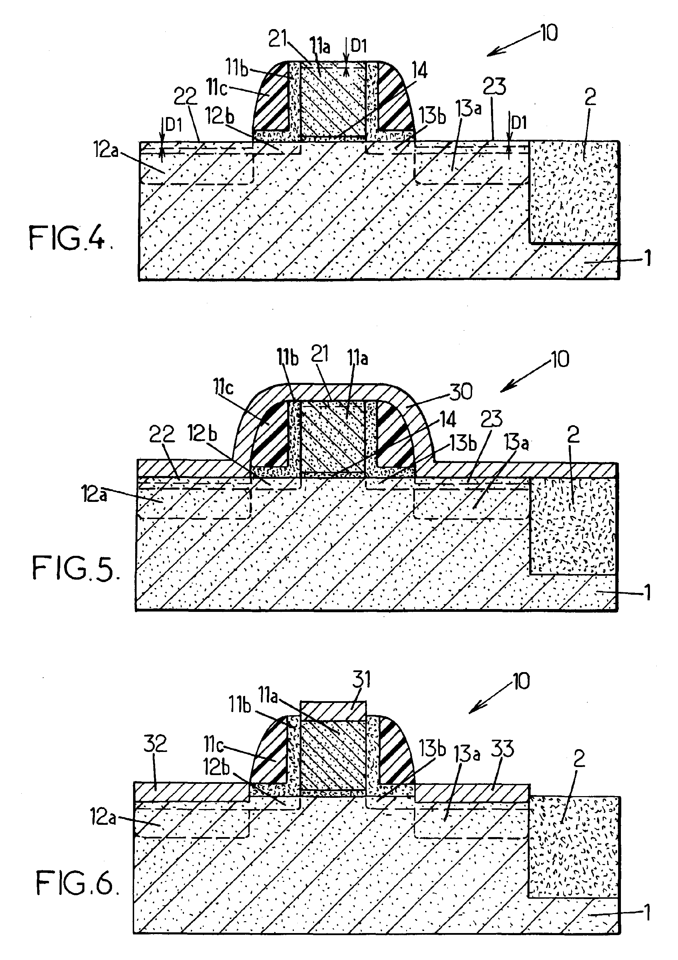

Dans une étape illustrée par le schéma de la figure 5, on procède ainsi au dépôt sur la structure d'une couche 30 de métal apte à former un siliciure lorsque il réagit thermiquement avec le silicium. Ce dépôt peut par exemple être effectué par pulvérisation.

Dans un exemple, le métal ainsi déposé est sélectionné dans le groupe comprenant Co, Ni, Pt, et Ti. '

On notera que la couche 30 est également une couche conforme, en ce sens qu'elle épouse les contours de la structure à la surface du substrat 1.

Ensuite, on effectue un traitement thermique, par exemple un traitement thermique rapide (ou RTP, de l'anglais "Rapid Thermal Processing"), qui fait réagir le métal de la couche 30 en contact avec le silicium des parties de silicium sous-jacentes 11 a, 12b et 13b. Il s'agit typiquement d'un chauffage par lampe. La réaction entre le métal et le silicium sous-jacent produit un siliciure correspondant à l'association du silicium avec le métal concerné.

Dans une étape finale, on procède au retrait du métal n'ayant pas réagi au traitement thermique de l'étape précédente, en sorte d'obtenir la configuration illustrée par le schéma de la figure 6.

Ainsi qu'on peut le voir, dans les zones où la réaction entre le métal et le silicium a eu lieu, il s'est formé au dessus des portions de silicium 11 a, 12b et 13b, des couches de siliciure respectivement 31, 32 et 33. La profondeur des couches 31, 32 et 33 à l'intérieur du substrat 1 est limitée par la profondeur D1 d'implantation des ions. En effet, les ions implantés font obstacle à la descente du siliciure dans le silicium, du fait que le siliciure de germanium est difficile à obtenir.

Dit autrement, la profondeur du siliciure créé est contrôlée par un choix approprié des conditions de l'implantation, pour une épaisseur de la couche d'isolant déterminé. En particulier, on peut faire varier l'énergie d'implantation pour mieux maîtriser la profondeur des zones siliciurées 31, 32 et 33 à l'intérieur des zones de silicium respectivement 11a, 12b et 13b par-dessus lesquelles elles sont réalisées.

On notera que la mise en oeuvre de l'invention est facilement détectable dans les dispositifs semi-conducteurs. On peut en effet constater la présence des ions implantés dans les zones siliciurées, plus précisément en dessous des couches de siliciure formées. On peut procéder par analyse de composition par spectroscopie de masse des ions secondaires (analyse SIMS, de l'anglais "Secondary Ion Mass Spectroscopy"), ou par une technique de détection des impuretés dans le silicium de type Auger ou similaire. Cette analyse et cette technique sont bien connues de l'Homme du métier.

L'invention concerne aussi un transistor MOS obtenu en mettant en oeuvre un procédé tel que décrit ci-dessus. Le transistor comprend une couche de siliciure, par exemple au dessus des zones de grille, de source et/ou de drain, ainsi que des ions implantés dans ces zones juste au dessous de la couche de siliciure, lesdits ions ayant la propriété de freiner la siliciuration des métaux.

L'invention concerne enfin un dispositif semi-conducteur comprenant un transistor MOS tel que décrit ci-dessus.

## Revendications

1. Procédé de formation de siliciure au dessus d'au moins une portion de silicium (11a,12b,13b) à la surface d'une plaque de matériau semi-conducteur (1 ), comprenant les étapes de :
a) implantation à une profondeur déterminée (D1) dans la portion de silicium, d'ions ayant la propriété de freiner la siliciuration des métaux ;
b) traitement thermique ;
c) dépôt d'une couche de métal (30), ledit métal étant apte à former un siliciure par réaction thermique avec le silicium ;
d) traitement thermique rapide adapté pour provoquer la siliciuration du métal déposé à l'étape c) ; et,
e) retrait du métal n'ayant pas réagi au traitement thermique de l'étape d) ;
et suivant lequel l'épaisseur du siliciure créé à l'étape d) est contrôlée par un choix approprié de la profondeur de l'implantation réalisée à l'étape a).

2. Procédé selon la revendication 1, suivant lequel l'implantation de l'étape a) est une implantation pleine plaque.

3. Procédé selon la revendication 1 ou la revendication 2, suivant lequel les ions implantés à l'étape a) sont des ions non dopants.

4. Procédé selon l'une quelconque des revendications précédentes, suivant lequel les ions implantés à l'étape a) sont des ions lourds.

5. Procédé selon l'une quelconque des revendications précédentes suivant lequel les ions implantés à l'étape a) sont sélectionnés dans le groupe comprenant des ions de Ge, Xe, et Ar.

6. Procédé selon l'une quelconque des revendications précédentes, suivant lequel le métal déposé à l'étape c) est sélectionné dans le groupe comprenant Co, Ni, Pt, et Ti.

7. Procédé selon l'une quelconque des revendications précédentes, suivant lequel, à l'étape a), les ions sont implantés à travers une couche de matériau diélectrique (20), qui est retirée lors d'une étape de retrait venant entre les étapes b) et c).

8. Procédé selon la revendication 7, suivant lequel la couche de matériau diélectrique est une couche de Si02 déposée à partir de TEOS, et servant également de masque pour une autre opération.

9. Procédé selon l'une quelconque des revendications précédentes, suivant lequel le traitement thermique de l'étape b) est un recuit d'activation d'espèces dopantes préalablement implantées dans la portion de silicium et/ou dans d'autres portions de la plaque.

10. Application d'un procédé selon l'une quelconque des revendications 1 à 9 à la fabrication d'un transistor MOS.

11. Transistor MOS comprenant une couche de siliciure au dessus d'une zone déterminée et comprenant en outre des ions implantés dans ladite zone juste au dessous de la couche de siliciure, lesdits ions ayant la propriété de freiner la siliciuration des métaux.

12. Dispositif semi-conducteur comprenant un transistor MOS selon la revendication 11.
